# EUROPÄISCHE PATENTSCHRIFT

(11) **EP 2 484 413 B1**
(45) Veröffentlichungstag und Bekanntmachung des Hinweises auf die Patenterteilung: **13.07.2016**
(21) Anmeldenummer: 12153836.7
(22) Anmeldetag: 03.02.2012
(51) Int. Cl.: A63C 5/075

(54) **Schwingungsdämpfer, insbesondere für Alpinski**
Vibration damper, in particular for downhill ski
Amortisseur de vibrations, notamment pour le ski alpin

(30) Priorität: 03.02.2011 DE 102011003596
(43) Veröffentlichungstag der Anmeldung: 08.08.2012
(73) Patentinhaber: MARKER Deutschland GmbH, 82377 Penzberg (DE)
(72) Erfinder: Brandl, Christian, 82467 Garmisch-Partenkirchen (DE); Mangold, Michael, 82491 Grainau (DE)
(74) Vertreter: Schwabe - Sandmair - Marx

(56) Entgegenhaltungen:
- CH-A5- 562 617
- DE-A1- 2 502 031
- DE-A1- 2 820 649
- DE-C1- 19 905 506
- JP-U- 62 192 763
- US-A- 4 018 454

## Beschreibung

Die Erfindung betrifft einen Schwingungsdämpfer für ein Gleitbrett, insbesondere in, an oder zur Anordnung in oder an dem Gleitbrett, insbesondere einem Schneegleitbrett wie z. B. einem Alpinski oder Snowboard.

Wie beispielsweise aus dem alpinen Skilauf bekannt, werden Ski bei der Fahrt durch äußere Kräfte zum Schwingen angeregt. Vor allem bei Kurvenfahrten und hohen Geschwindigkeiten können Schwingungen das Fahrverhalten des Skis erheblich beeinflussen. In Fahrsituationen, in denen der Fahrer den Ski im Grenzbereich fährt, wie z. B. bei Skirennläufen tragen auch Schwingungen des Skis zur Abweichung von der idealen Fahrlinie bei.

Die Anmelderin hat herausgefunden, dass insbesondere horizontale Schwingungen des Skis unerwünscht sind. Unter horizontalen Schwingungen werden Schwingungen verstanden, die parallel zum Skibelag oder der Skiunterseite und insbesondere quer zur Längsachse des Skis gerichtet sind. Der Ski wird abhängig von der Fahrweise oftmals bis zu 97% auf seinen Kanten gefahren. Horizontale Schwingungen des Skis bewirken bei Kurvenfahrten eine Veränderung der Anpresskraft der Skikante mit dem Untergrund und können somit das Fahrverhalten beeinflussen.

Aus der DE 27 09 517 A1 ist es bekannt, am vorderen und hinteren Ende des Skis starre Zusatzmassen auf der Skioberseite anzubringen.

Die DE 28 20 649 A1 beschreibt einen Schwingungsdämpfer, der auf der Oberseite eines Skis befestigbar ist und eine elastisch oder federnd aufgehängte Masse aufweist, die in mehreren Freiheitsgraden schwingen kann.

Die DE 26 45 167 A1 offenbart einen Skiabweiser mit einstellbarer Schwingungsdämpfung. Zwischen einer Grundplatte und einer Abdichtung des Skiabweisers wird ein Vakuum erzeugt.

Die EP 0 429 087 A2 offenbart einen Ski, der mit einer Vibrationsdämpfungseinrichtung ausgestattet ist. In einer Ausführungsform ist eine Metallolive an einer verformbaren Membran befestigt. Die Metallolive und die Membran sind in einer sich von der Skioberseite zu der Skiunterseite durchgehend erstreckenden Ausnehmung in der Skispitze angeordnet, wobei die Membran die Ausnehmung verschließt. Die Metallolive kann aufgrund ihrer Anordnung an der Membran mit einer Vielzahl von Freiheitsgraden schwingen, ähnlich wie bei der Aufhängung aus der DE 28 20 649 A1.

In der US 4,018,454 A wird mit Bezug auf Figur 1 ein Massestück offenbart, welches relativ zu einem Rahmen bewegbar ist. Das Massestück kann lediglich auf und ab schwingen und ist somit für Bewegungen entlang einer Geraden geführt.

Die CH 562 617 A5 offenbart ebenfalls ein Massestück in Form einer Kugel, welche an dem Gehäuse geführt wird. Die Kugel ist für Bewegungen entlang einer Geraden geführt.

In den Figuren 4 bis 9 der JP 62-192763 U wird jeweils ein Massestück offenbart, welches von einem Gehäuse entlang einer Geraden geführt wird. In den Figuren 11 bis 13 der JP 62-192763 U wird ein Massestück offenbart, welches an einer Membran angeordnet ist und ungeführt frei im Raum bewegbar ist.

Es ist eine Aufgabe der Erfindung, einen Schwingungsdämpfer anzugeben, der einem Gleitbrett, insbesondere einem Schneegleitbrett, verbesserte Fahreigenschaften verleiht. Es ist ferner eine Aufgabe der Erfindung, ein Gleitbrett anzugeben, das verbesserte Fahreigenschaften aufweist. Die Aufgabe wird durch den Schwingungsdämpfer nach Anspruch 1 und dem Gleitbrett nach Anspruch 13 gelöst. Vorteilhafte Weiterentwicklungen ergeben sich aus den abhängigen Ansprüchen, der Beschreibung und den Figuren.

Ein erster Aspekt der Erfindung betrifft einen Schwingungsdämpfer für ein Gleitbrett, insbesondere in, an oder zur Anordnung, insbesondere Befestigung in oder an einem Gleitbrett, insbesondere einem Schneegleitbrett. Ein zweiter Aspekt betrifft ein Gleitbrett, insbesondere ein Schneegleitbrett mit einem Schwingungsdämpfer.

Bei dem Schneegleitbrett kann es sich z. B. um einen Alpinski oder um ein Snowboard handeln. Das Gleitbrett weist eine Oberseite und eine der Oberseite gegenüber liegende Unterseite mit einem Belag oder Gleitbelag auf und ist länglich ausgestaltet. Die Unterseite dient zum Kontakt mit dem Untergrund, wie z.B. einer Skipiste. An der Oberseite kann eine Bindung befestigt oder befestigbar sein, mit der das Gleitbrett an mindestens einem Bein eines Menschen oder einem Skistiefel befestigbar ist. Das Gleitbrett weist an seinem vorderen Ende einen hochgezogenen Bereich, insbesondere eine Skispitze auf, und kann am hinteren Ende flach oder ebenfalls mit einem hochgezogenen Bereich ausgestaltet sein. Das Gleitbrett kann an seinen beiden entlang der Längsrichtung des Gleitbretts erstreckten Flanken jeweils eine bevorzugt aus Stahl eingesetzte Kante aufweisen.

Ein bevorzugtes Gleitbrett, insbesondere ein Alpinski weist eine Vorspannung auf, wodurch das Gleitbrett mit nur zwei Bereichen, nämlich einem vorderen Auflagebereich und einem hinteren Auflagebereich auf einem ebenen Untergrund aufliegt, wenn das Gleitbrett mit seiner Unterseite auf den ebenen Untergrund aufgelegt wird. Vorne und hinten beziehen sich insbesondere auf die vorgesehene Fahrtrichtung des Schneegleitbrettes.

Das Gleitbrett kann den Schwingungsdämpfer aufweisen, d. h. der Schwingungsdämpfer kann ein integraler oder ein nachträglich angebrachter Bestandteil des Gleitbretts sein. In einer bevorzugten Variante ist der Schwingungsdämpfer so ausgestaltet, dass er nachträglich an ein bestehendes Gleitbrett anbringbar ist. Ein erfindungsgemäßer Schwingungsdämpfer kann in Bezug auf die Längsrichtung des Gleitbretts an dem vorderen Auflagebereich oder/und an dem hinteren Auflagebereich besonders vorteilhaft angeordnet sein oder werden. Der Schwingungsdämpfer kann auf der der Unterseite gegenüber liegenden Oberseite des Gleitbretts befestigt sein oder werden.

Der Schwingungsdämpfer umfasst einen Rahmen, der an dem Schneegleitbrett, insbesondere auf dessen Oberseite, befestigt oder befestigbar ist, insbesondere mit seiner Unterseite. Hierzu kann an der Unterseite des Rahmens eine Klebeschicht angeordnet sein oder werden, mit welcher der Rahmen bzw. der Schwingungsdämpfer an das Gleitbrett anklebbar ist. Die Unterseite des Rahmens, wie z.B. ein Adapter des Rahmens, kann an die Form der Oberfläche der Oberseite des Gleitbretts angepasst, wie z.B. flach oder gewölbt sein. Ein Adapter hat den Vorteil, dass der Schwingungsdämpfer für verschiedene Gleitbrettmodelle eingesetzt werden kann, wobei nur der Adapter an die Form der Oberfläche der verschiedenen Gleitbrettmodelle angepasst werden braucht.

Die Klebeschicht kann aus einem Flüssigkleber, wie z. B. einem Zweikomponentenklebstoff gebildet werden. Als besonders vorteilhaft hat sich jedoch eine Klebeschicht aus einer Klebefolie oder einem Klebeband erwiesen. Die Klebefolie oder das Klebeband, die oder das bevorzugt doppelseitig klebend sein kann, kann mit einer Seite an dem Rahmen befestigt, insbesondere angeklebt sein, wobei die andere Seite von einer Abziehfolie abgedeckt sein kann. Der Schwingungsdämpfer kann gegebenenfalls nach dem Abziehen der Abziehfolie an dem Gleitbrett befestigt werden.

Als besonders vorteilhaft hat sich eine Klebeschicht erwiesen, die Acrylschaum, insbesondere geschlossenporigen Acrylschaum umfasst. Eine Klebeschicht mit Acrylschaum ist einerseits so stabil, dass sich der Schwingungsdämpfer selbst bei starker Vibration des Gleitbretts nicht von dem Gleitbrett löst, und entkoppelt andererseits die Steifigkeit des Schwingungsdämpfers von der des Gleitbretts. Wäre der Klebstoff zu hart, würde er einerseits die Steifigkeit des Schwingungsdämpfers auf das Gleitbrett übertragen und könnte andererseits die Klebeverbindung durch starke Vibrationen zerstört werden.

Alternativ kann der Schwingungsdämpfer an dem Gleitbrett angeschraubt oder angenietet werden.

In einer zweiten bevorzugten Variante ist der Schwingungsdämpfer in dem Gleitbrett integriert oder integraler, insbesondere unlösbarer, d. h. nicht ohne Zerstörung des Gleitbretts oder des Schwingungsdämpfers lösbarer Bestandteil des Gleitbretts. Insbesondere kann der Schwingungsdämpfer bei der Herstellung des Gleitbretts in das Gleitbrett integriert, insbesondere form- und/oder stoffschlüssig integriert werden, insbesondere durch Einkleben, Umgießen oder Einlaminieren. Zumindest der Rahmen des Schwingungsdämpfers kann in dem Gleitbrett, insbesondere in dem ihn umgebenden Material des Gleitbretts, verankert sein. Ist der Rahmen mehrteilig, kann z. B. ein Teil, wie z. B. ein Sockel verankert sein, wobei ein anderes Teil, wie z. B. ein Deckel, an dem Rahmen optional lösbar oder vorzugsweise unlösbar befestigbar oder befestigt ist. Der Rahmen kann optional einstückig sein.

Der Schwingungsdämpfer oder dessen Rahmen kann z. B. so in dem Gleitbrett integriert sein, dass der Rahmen unterhalb der Oberseite, d. h. deren Oberfläche, angeordnet ist und z. B. von einer Sicht- oder Dekorschicht überdeckt wird, oder dass der Rahmen bündig mit der Oberseite, d. h. deren Oberfläche, abschließt und z. B. sichtbar ist, oder dass der Rahmen aus dem Gleitbrett über die Oberseite, d. h. deren Oberfläche, ragt und insbesondere sichtbar ist. Der Schwingungsdämpfer oder dessen Rahmen kann über der Unterseite des Gleitbretts, d. h. verdeckt von der Unterseite des Gleitbretts, integriert oder/und insbesondere vollständig zwischen Oberseite und Unterseite des Gleitbretts angeordnet sein.

Insbesondere kann der Schwingungsdämpfer so in das Gleitbrett integriert sein, dass er nicht sichtbar ist. Bevorzugt ist jedoch, dass zumindest ein Teil des Schwingungsdämpfers, wie z. B. ein Massestück sichtbar ist. Die Oberseite, insbesondere deren Oberfläche, kann eine Öffnung aufweisen, durch welche das Massestück von außen sichtbar ist oder insbesondere aus dem Gleitbrett über die Oberseite, insbesondere deren Oberfläche oder Sicht- oder Dekorschicht, ragt.

Das Massestück kann gegenüber der Umgebung des Gleitbretts abgedeckt sein, insbesondere mit einem transparenten Material oder Kunststoff, so dass das Massestück von außen sichtbar bleibt. Z. B. kann die Öffnung von dem transparentren Material verschlossen sein, wobei das transparente Material bündig mit der Oberfläche der Oberseite abschließen kann und/oder die Oberseite des Massestücks unterhalb der Oberseite des Gleitbretts angeordnet sein kann. Das transparente Material kann alternativ konvex nach außen gewölbt sein, wobei die Oberseite des Massestücks z. B. über die Oberseite des Gleitbretts ragen kann.

Der Schwingungsdämpfer umfasst im Allgemeinen ein mehr- oder bevorzugt einteiliges Massestück, welches relativ zu dem Rahmen bewegbar ist. Bevorzugt fasst der Rahmen das Massestück über seinen Umfang ein. Der Rahmen kann das Massestück ringförmig umgeben. Das Massestück kann eine Dichte aufweisen, die größer ist als die Dichte des Rahmens und eines weiter unten beschriebenen Elastizitätsmittels. Bevorzugt weist das Massestück eine hohe Dichte auf, z. B. eine Dichte ≥ 7g/cm³. Das Massestück kann z. B. aus einem Zinkdruckgussteil gefertigt sein. Der Rahmen kann beispielsweise aus Aluminium oder Kunststoff gefertigt sein. Durch eine relativ hohe Dichte des Massestücks kann der Schwingungsdämpfer kompakt gebaut werden. Grundsätzlich wäre es auch möglich, das Massestück aus einem Material geringer Dichte, wie z. B. Aluminium herzustellen, wobei das Massestück dann entsprechend groß sein müsste, wodurch der Schwingungsdämpfer ebenfalls an Baugröße zunehmen würde.

Als vorteilhaft hat sich eine Masse für das Massestück von 75g +/- 25g, d. h. eine Masse zwischen 50g und 100g, erwiesen. Die Masse kann je nach der zu erwartenden Fahrgeschwindigkeit, Fahrdynamik, Fähigkeiten des Fahrers, usw. angepasst sein. Die Masse des Massestücks kann beispielsweise für den alpinen Ski-Rennsport abhängig von dem Wettbewerb, wie z. B. Slalom, Riesenslalom, Super-G, Abfahrt, usw. angepasst sein.

In bevorzugten Ausführungen kann der Rahmen einen Sockel und einen mit dem Sockel verbundenen Deckel aufweisen. Der Sockel kann die Unterseite des Schwingungsdämpfers bilden. An der Unterseite des Sockels kann die oben erwähnte Klebeschicht angeordnet sein. Alternativ kann die Unterseite fest in dem Gleitbrett verankert sein.

Der Deckel kann mit dem Sockel verschraubt oder verklippst oder verrastet oder vernietet oder auf eine andere Weise verbunden sein. Der Deckel kann die Oberseite des Schwingungsdämpfers bilden. Der Deckel kann eine Öffnung aufweisen, durch die ein Teil des Massestücks ragt oder zumindest sichtbar ist. Der Deckel kann alternativ z. B mit einem transparenten Material verschlossen sein, so dass das Massestück sichtbar ist. Allgemein bevorzugt ist der Deckel so gestaltet, dass das Massestück von außen sichtbar, d.h. inspizierbar ist.

Der Schwingungsdämpfer umfasst ferner ein Elastizitätsmittel, an dem das Massestück befestigt ist und das spannbar ist, indem das Massestück relativ zu dem Rahmen bewegt wird. Das Massestück kann eine Ruheposition einnehmen, wenn - abgesehen von nicht vermeidbaren Kräften, wie z.B. die Erdgravitation - keine äußeren Kräfte auf das Massestück einwirken. Bei einer Bewegung oder Auslenkung des Massestücks aus seiner Ruheposition wird das Elastizitätsmittel gespannt, so dass das Elastizitätsmittel eine Rückstellkraft für das Massestück in seine Ruheposition erzeugt. Das Prinzip beruht auf einem Einmassenschwinger. Das Elastizitätsmittel kann beispielsweise eine Feder sein. Da eine Feder eine verhältnismäßig geringe Dämpfung aufweist, kann ein zusätzliches Dämpfungsglied vorgesehen sein, welche eine Schwingung des Massestücks dämpft.

In besonders bevorzugten Ausführungen ist das Elastizitätsmittel eine elastische Membran, die an dem Rahmen befestigt ist. Im Gegensatz zu einer Feder stellt die Membran einen relativ hohen Dämpfungswert bereit. Dadurch wird eine aufgrund auf das Massestück wirkende äußere Kräfte hervorgerufene Schwingung des Massestücks verhältnismäßig stark gedämpft. Das Elastizitätsmittel dissipiert somit Schwingungsenergie des Massestücks, wodurch dem Gleitbrett bei der Fahrt Schwingungsenergie entzogen wird.

Es ist nicht immer wünschenswert, sämtliche Schwingungen des Gleitbretts zu dämpfen, da hierdurch die Agilität des Skis möglicherweise negativ beeinflusst werden kann. Die Anmelderin hat herausgefunden, dass es vorteilhaft ist, die horizontalen Schwingungen eines Gleitbretts zu reduzieren. Erfindungsgemäß ist das Massestück so an dem Schwingungsdämpfer angeordnet, dass es für Bewegungen in einer Ebene geführt ist. Damit zeichnet sich die Erfindung gegenüber den Schwingungsdämpfern aus DE 28 20 649 A1 und EP 0 429 087 A2 aus, die lehren, das Massestück ungeführt an einer Membran anzuordnen, so dass Schwingungen unselektiv gedämpft werden.

Dadurch, dass das Massestück in einer Ebene geführt, d. h. nur mit zwei translatorischen Freiheitsgraden bewegbar ist, können insbesondere horizontale Schwingungen des Schneegleitbretts gedämpft werden. Das Massestück wird so geführt, dass es nur in einer Ebene bewegbar ist.

Die Ebene, in der das Massestück geführt ist oder in der es bewegbar ist, ist bevorzugt in etwa parallel zu der Unterseite des Schwingungsdämpfers oder des Rahmens oder zu der Gleitfläche auf der Unterseite des Gleitbretts. Das Massestück kann dadurch nur in Richtung der Breite und der Länge des Schneegleitbretts oder des Schwingungsdämpfers relativ zu dem Rahmen des Schwingungsdämpfers oder relativ zu dem Schneegleitbrett bewegt werden.

Bewegungen des Massestücks entlang der Höhe des Schwingungsdämpfers oder des Schneegleitbretts werden verhindert, abgesehen von einem gewissen Spiel, das für die Bewegbarkeit des Massestücks in der Ebene erforderlich ist.

Der Schwingungsdämpfer weist eine Führung auf, welche das Massestück für Bewegungen in einer Ebene führt. Die Führung ist bevorzugt in oder/und parallel zu der Ebene angeordnet, in der das Massestück bewegbar ist. Die Führung kann einen Teil des Massestücks, wie z. B. einen um das Massestück vollständig oder unterbrochen umlaufenden Flansch einfassen. Das Massestück kann mittels einer unteren Führungsfläche und einer oberen Führungsfläche, welche parallel zu der Ebene sind, in der sich das Massestück bewegt, geführt werden. Die obere Führungsfläche kann von dem Rahmen, insbesondere dem Deckel oder einer daran befestigten Dichtung, und die untere Führungsfläche kann von dem Rahmen, insbesondere dem Sockel, oder bevorzugt von der Membran gebildet werden.

Bevorzugt ist das Massestück zwischen dem Sockel und dem Deckel geführt. Dementsprechend kann die Führung für das Massestück zwischen dem Sockel und dem Deckel angeordnet sein. Der Abstand zwischen den Führungsflächen ist um ein ausreichendes Spiel größer als die Dicke des Flanschs des Massestücks. Zu der Dicke des Flanschs des Massestücks kann auch eine weiter unten beschriebene Dichtung beitragen. Allgemein wird bevorzugt, dass der Sockel und/oder der Rahmen das Massestück über den Umfang des Massestücks bevorzugt ringförmig umgeben.

Zwischen dem Massestück und dem Rahmen, vorzugsweise dem Deckel und/oder dem Sockel kann eine oder je eine Dichtung angeordnet sein. Die Dichtung dient dazu, das Eindringen von beispielsweise Schnee oder Eis in die Führung des Schwingungsdämpfers zu verhindern. Die Dichtung kann zumindest einen Teil des Massestücks ringförmig umgeben und/oder formschlüssig mit dem Massestück verbunden sein. Die Dichtung kann sich somit mit dem Massestück bewegen. Beispielsweise kann das Massestück eine Vielzahl von Ausnehmungen aufweisen, in welche Eingriffsglieder der Dichtung eingreifen. Alternativ kann die Dichtung die Ausnehmungen und das Massestück die Eingriffsglieder aufweisen.

Sofern die Dichtung an dem Rahmen oder dem Deckel befestigt ist, kann sich das Massestück relativ zu der Dichtung bewegen. Die Dichtung kann eine Führungsfläche für das Massestück bilden.

Die Membran kann z. B. aus Gummi, insbesondere aus einem flächigen Gummimaterial gebildet sein. Bevorzugt kann die Membran aus einem flächigen Silikonmaterial gebildet, wie z. B. ausgestanzt sein. Silikon hat den Vorteil, dass es auch noch bei -30°C ausreichende Elastizitätswerte aufweist.

Besonders bevorzugt ist die Membran aus einem thermoplastischen Polyurethan gebildet. Die Membran lässt sich hierzu besonders vorteilhaft im Spritzguss herstellen. Um auch bei niedrigen Temperaturen, wie z. B. bis -23°C ausreichende Elastizität zu gewährleisten, ist das thermoplastische Polyurethan besonders bevorzugt kältemodifiziert. Dadurch, dass die Membran im Spritzguss hergestellt werden kann, ist sie besonders kostengünstig zu fertigen.

Allgemein wird für die Membran eine Härte von 40 bis 70 Shore-A bevorzugt. Die Membran kann eine Dicke von beispielsweise 0,5mm bis 2mm, vorzugsweise 1mm aufweisen.

Zur Einstellung der Steifigkeit der Membran bzw. deren mechanische Eigenschaften können z. B. mehrere Ausnehmungen oder Löcher in der Membran vorgesehen sein, insbesondere zwischen der Stelle, an der der Massekörper an der Membran befestigt ist, und den Befestigungsstellen, an denen die Membran an dem Rahmen befestigt ist.

Zur Befestigung der Membran an dem Rahmen können mehrere, d.h. mindestens zwei oder drei Befestigungsstellen vorgesehen sein, die in einer gemeinsamen Befestigungsebene angeordnet sind. Die Befestigungsebene ist vorzugsweise parallel zu der Ebene, in der das Massestück bewegbar ist. Der Rahmen und die Membran können formschlüssig ineinander greifen. Insbesondere sind die Befestigungsstellen so ausgestaltet, dass die Membran gegen Lösen von dem Rahmen an den Befestigungsstellen aufgrund in oder parallel zu der Befestigungsebene wirkenden oder aufgrund der geführten Bewegung des Massestücks in der Membran hervorgerufenen Spannkräften mittels formschlüssigen Verbindungen zwischen Membran und Rahmen gesichert ist. Grundsätzlich ist es aber auch möglich, die Membran z. B. zwischen dem Deckel und dem Sockel nur einzuklemmen, d. h. die Membran mit dem Rahmen kraftschlüssig zu verbinden, allerdings kann hierbei die Gefahr bestehen, dass bei der Bewegung des Massestücks relativ zu dem Gehäuse die Membran aus der kraftschlüssigen Verbindung herausgezogen wird. Um dies zu verhindern wird eine formschlüssige Verbindung zwischen Membran und Rahmen bevorzugt, die ein Ausziehen der Membran aus den Verbindungsstellen verhindert.

Beispielsweise können die Membran über ihren Umfang eine Vielzahl von Ausnehmungen und der Rahmen eine Vielzahl von Abragungen aufweisen. In je eine Ausnehmung kann eine bzw. je eine Abragung eingreifen. Z. B. können die Abragungen an dem Sockel gebildet sein und in Richtung Deckel weisen. Die Ausnehmungen können im Randbereich der Membran über deren Umfang verteilt sein. Die Ausnehmungen lassen sich auf einfache Weise durch Stanzen oder durch Spritzgießen an die Membran anformen.

Das Massestück kann bevorzugt quer, insbesondere senkrecht zu einer Flächennormalen der Membran oder der Befestigungsebene bewegt werden. Mit an deren Worten kann das Massestück parallel zur Befestigungsebene der Membran bewegt werden.

Die Gestaltung des Schwingungsdämpfers lässt eine besonders kompakte und insbesondere für den alpinen Skirennsport vorteilhafte flache Ausgestaltung zu. Insbesondere ist die von der Unterseite zu der Oberseite des Schwingungsdämpfers erstreckte Höhe kleiner als die quer zur Höhe erstreckte Länge und/oder Breite des Schwingungsdämpfers. Besonders bevorzugt ist die Höhe kleiner als die Hälfte oder ein Drittel der Länge und/oder der Breite.

Die Erfindung wurde anhand mehrerer vorteilhafter Ausgestaltungen beschrieben. Im Folgenden werden besonders bevorzugte Ausführungen anhand von Figuren beschrieben. Die dabei offenbarten Merkmale bilden den Gegenstand der Erfindung einzeln und in jeder Merkmalskombination vorteilhaft weiter. Es zeigen:
- Figur 1: die Seitenansicht eines Schwingungsdämpfers nach einer ersten Ausführungsform,
- Figur 2: die Draufsicht auf den Schwingungsdämpfer aus Figur 1,
- Figur 3: die Ansicht aus Figur 1 im Vollschnitt,
- Figur 4: eine perspektivische Ansicht des Schwingungsdämpfers aus Figur 1,
- Figur 5: eine Explosionsdarstellung des Schwingungsdämpfers aus Figur 1,
- Figur 6: eine Seitenansicht im Vollschnitt durch einen Schwingungsdämpfer nach einer zweiten Ausführungsform,
- Figur 7: eine perspektivische Ansicht des Schwingungsdämpfers aus Figur 6 und
- Figur 8: eine Explosionsansicht der Einzelteile des Schwingungsdämpfers aus Figur 6.

Für die Beschreibung der ersten Ausführungsform und der zweiten Ausführungsform bezeichnen gleiche Bezugszeichen gleichartige Teile. Obwohl die zweite Ausführungsform zum Aufkleben auf ein Gleitbrett beschrieben wird, sind die Schwingungsdämpfer gemäß erster und zweiter Ausführungsform so zu verstehen, dass sie alternativ integraler Bestandteil des Gleitbretts oder in dem Gleitbrett angeordnet sein können, wie in dieser Anmeldung beschrieben wird.

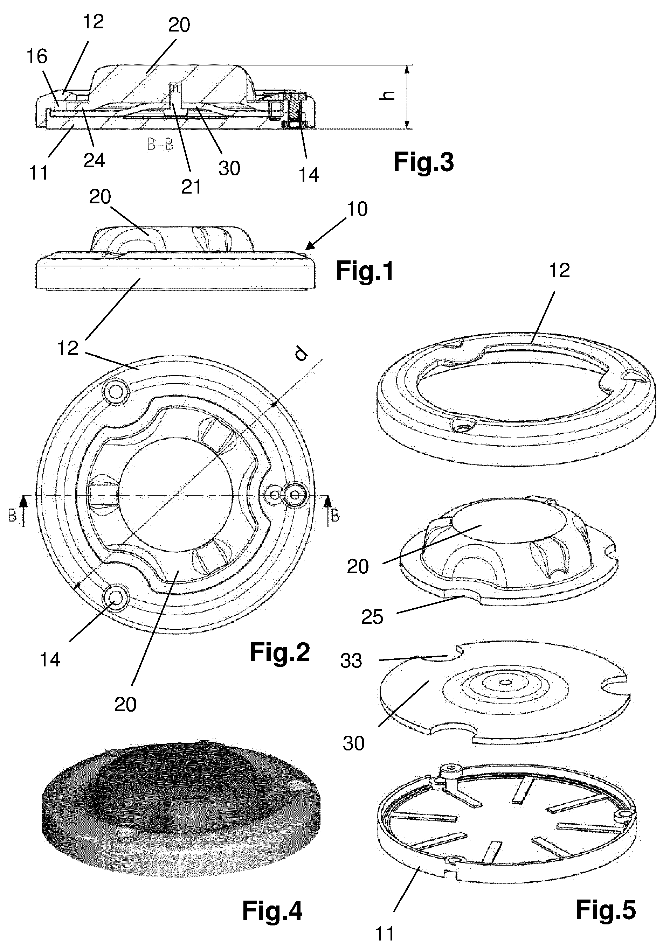

In den Figuren 1 bis 5 wird ein Schwingungsdämpfer nach einer ersten Ausführungsform gezeigt, welcher einen Rahmen 10, ein Massestück 20 und eine Membran 30 umfasst, wie am besten aus der Zusammenschau der Figuren 1 und 3 erkennbar ist.

Der Rahmen 10 weist einen Sockel 11 und einen Deckel 12 auf, der auf den Sockel 11 aufgesetzt und mit mehreren, in diesem Beispiel drei gleichmäßig über den Umfang des Deckels 12 verteilte Schrauben 14 mit dem Sockel 11 verbunden ist. Der Sockel 11 weist eine als Außenumfangsfläche gestaltete Zentrierfläche auf, an der sich der Deckel 12 zentriert. Der Sockel 11 ist plattenförmig und an seiner Unterseite, d. h. der von dem Schwingungsdämpfer wegweisenden Seite geschlossen. Der Sockel 11 weist an seiner nach innen weisenden Grundfläche mehrere, in diesem Beispiel acht radial nach innen ragende Stege auf, die jeweils eine Auflagefläche für die Membran 30 bilden. Durch die Stege wird verhindert, dass sich die Membran 30 auf der Grundfläche festlegt. Der Sockel 11 weist ferner Bohrungen für die Befestigungsschrauben 14 auf. Für jede der Befestigungsschrauben 14 weisen die Membran 30 und der Massenkörper 20 entsprechend der Anzahl und der Verteilung der Befestigungsschrauben 14 über den Umfang angeordnete Ausnehmungen 33, 25 auf, die sich von der Außenkante her in Richtung Mitte des Massestücks 20 und der Membran 30 erstrecken.

Die Membran 30 ist mit dem Massestück 20 über eine Befestigungsschraube 21 verbunden, deren Schaft durch die Membran 30 gesteckt ist und mit einer Gewindebohrung verschraubt ist, die an der zur Grundfläche des Sockels 11 weisenden Seite des Massestücks 20 angeordnet ist. Die Membran 30 wird dabei zwischen dem Massestück 20 und dem Schraubenkopf der Befestigungsschraube 21 eingeklemmt.

Die Membran 30 ist im Randbereich über dem Umfang zwischen dem Sockel 11 und dem Deckel 12 eingeklemmt, d. h. kraftschlüssig befestigt.

Das Massestück 20 weist über seinen Umfang einen Flansch 24 auf, der in einer zwischen dem Sockel 11 und dem Deckel 12 gebildeten Führung 16 eingefasst ist. Die Führung 16 wird von einer Führungsfläche des Deckels 12 und einer dieser Führungsfläche gegenüber liegenden Führungsfläche der Membran 30 gebildet. Der Abstand zwischen den Führungsflächen ist etwas größer als die Dicke des Flanschs 24, so dass ein Einklemmen des Flanschs 24 zwischen dem Deckel 12 und der Membran 30 verhindert wird. Wie am besten aus Figur 3 erkennbar ist, ist zwischen dem Flansch 24 und dem Deckel 12 radial ein über den Umfang verlaufender Ringspalt gebildet, der eine Bewegung des Massestücks 20 relativ zu dem Rahmen 10 erlaubt. Durch die Ausgestaltung der Führung 16 lässt sich das Massestück 20 nur in einer Ebene, d. h. mit zwei translatorischen Freiheitsgraden geführt bewegen. Bewegungen in Richtung der Höhe h werden durch die Führung 16 verhindert. Bewegungen quer oder senkrecht zur Höhe h werden hingegen erlaubt.

Der Deckel 12 ist ringförmig und weist eine Öffnung auf, durch die ein Hauptabschnitt des Massestücks 20 ragt. Die Höhe h des Schwingungsdämpfers wird in dem gezeigten Beispiel zwischen der Oberseite des Massestücks 20 und der Unterseite des Sockels 11 gebildet.

Der Deckel 12 weist in den Bereichen seiner Befestigungsschrauben 14 Ausbuchtungen auf, welche in die Öffnung für das Massestück 20 ragen. Diese Ausbuchtungen greifen in entsprechende Einbuchtungen des Massestücks 20 soweit ein, dass eine Verdrehung des Massestücks 20 relativ zu dem Rahmen 10 nicht oder nur kaum und eine Bewegung des Massestücks 20 relativ zu dem Rahmen 10 in der Ebene dennoch möglich ist. Zwischen dem Hauptabschnitt des Massestücks 20 und dem Deckel 12 ist ein Ringspalt gebildet, der die Bewegung des Massestücks 20 in der Ebene zulässt.

Der Schwingungsdämpfer bzw. der Rahmen 10 ist, wie am besten aus Figur 2 ersichtlich ist, kreisrund und weist einen Durchmesser d auf, wodurch die Länge und die Breite des Schwingungsdämpfers gleich sind. Das Verhältnis von Höhe zur Länge/Breite oder zum.

Durchmesser d ist in dem gezeigten Beispiel kleiner als 1:3. Dadurch baut der Schwingungsdämpfer verhältnismäßig kompakt.

Wie am besten aus Figur 3 ersichtlich ist, ist der Kopf der Befestigungsschraube 21 zwischen dem Sockel 11 und der Membran 30 angeordnet, wobei die Membran 30 zu dem Massestück 20 hin gewölbt ist. Die Befestigungsstellen, an denen die Membran 30 zwischen dem Deckel 12 und dem Sockel 11 eingeklemmt ist, liegen in einer gemeinsamen Befestigungsebene, die parallel ist zu der Ebene ist, in welcher das Massestück 20 bewegbar ist.

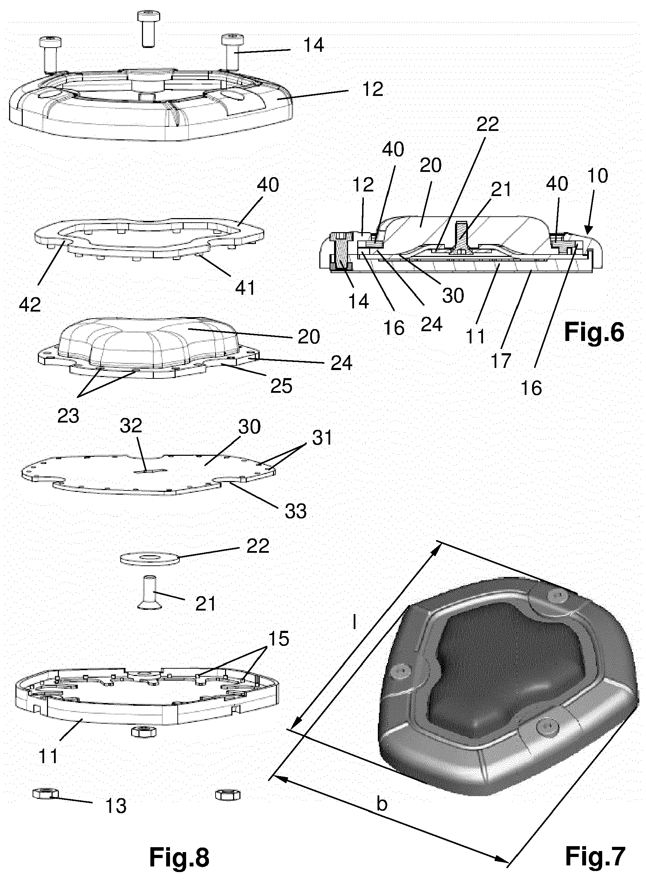

Das in den Figuren 6 bis 8 beschriebene zweite Ausführungsbeispiel entspricht im Wesentlichen dem des ersten Ausführungsbeispiels, weshalb auf das erste Ausführungsbeispiel verwiesen wird. Die wichtigsten Unterschiede werden im Folgenden erklärt.

Wie am besten aus Figur 7 erkennbar ist, ist der Schwingungsdämpfer hinsichtlich seiner äußeren Kontur nicht kreisförmig sondern weist eine Länge 1 und eine Breite B auf. Die Länge L erstreckt sich in Gleitbrett- oder Skilängsrichtung und die Breite b erstreckt sich in Richtung der Gleitbrett- oder Skibreite, wenn der Schwingungsdämpfer auf die dafür geeignete Stelle eines Skis aufgesetzt wird oder ist. Das Verhältnis der Höhe des Schwingungsdämpfers zu der maximalen Länge und/oder der maximalen Breite des Schwingungsdämpfers ist kleiner als 1:3.

Der plattenförmige Sockel 11 weist an seiner Unterseite je eine Ausnehmung für je eine Mutter für jede der Befestigungsschrauben 14 auf, mit denen der Deckel 12 an dem Sockel 11 befestigt wird. Die Muttern 13 sind somit verdrehgesicherte Gewindeeinsätze des Sockels 11, das somit z. B. aus Kunststoff herstellbar ist, wobei die vorzugsweise aus Stahl hergestellten Muttern 13 die notwendige Stabilität für die Befestigungsschrauben 14 bieten. An der Unterseite des Sockels 11 ist eine Klebeschicht 17 in der Gestalt einer doppelseitig klebenden Klebebands oder einer doppelseitig klebenden Klebefolie angeordnet. Obgleich die Klebeschicht 17 nur in Figur 6 eingezeichnet ist, kann sie auch vorteilhaft an der Unterseite des Schwingungsdämpfers, insbesondere an dessen Sockel 11, nach der ersten Ausführungsform vorgesehen sein.

Die Membran 30 weist in dem Randbereich ihres Umfangs eine Vielzahl von Ausnehmungen 31 auf. Der Sockel 11 weist entsprechend der Anzahl der Ausnehmungen 31 eine Vielzahl von Abragungen 15 auf, welche in Richtung Deckel 12 und Membran 30 abragen. In je eine Ausnehmung 31 greift eine Abragung 15 ein. Hierdurch werden mehrere in einer Befestigungsebene liegende Befestigungsstellen für die Membran 30 mit dem Rahmen 10 gebildet, wobei ein Lösen der Membran 30 von dem Rahmen 10 oder dem Sockel 11 formschlüssig verhindert wird, wenn das Massestück 20 in einer Ebene parallel zu der Befestigungsebene bewegt wird. Die Membran 30 braucht lediglich zwischen dem Deckel 12 und dem Sockel 11 eingefasst werden und muss wegen des formschlüssigen Eingriffs nicht unbedingt geklemmt werden.

Die Membran 30 weist ferner einen unrunden Durchgang 32 auf, in den eine entsprechend unrunde Abragung, die an der zur Membran 30 oder dem Sockel 11 weisenden Seite des Massestücks 20 angeordnet ist, eingreift, um eine Verdrehung zwischen Massestück 20 und Membran 30 zu verhindern oder zusätzlich zu verhindern. Die Membran 30 ist zwischen einer Beilagscheibe 22 und dem Massestück 20 eingefasst oder eingeklemmt. Durch die Größe der Beilagscheibe kann das Schwingungsverhalten der Membran 30 beeinflusst werden. Die Beilagscheibe 22 ist zwischen dem Massestück 20 und dem Schraubenkopf der Befestigungsschraube 21 angeordnet.

Das Massestück 20 weist an seinem Flansch 24 eine Vielzahl von Ausnehmungen 23 auf, wobei in jede der Ausnehmungen 23 eine Abragung 41 einer auf den Flansch 24 aufgesetzten Dichtung 40 eingreift. Die Dichtung 40 umgibt den Hauptabschnitt des Massestücks 20 ringförmig und ist entsprechend an die Außenkontur des Massestücks 20 angepasst, insbesondere hinsichtlich seiner Form. Die Dichtung 40 weist ferner entsprechend der Anzahl und Verteilung der Befestigungsschrauben 40 Ausnehmungen 42 auf, ebenso wie das Massestück 20 und die Membran 30. Die Dichtung 40 dient dazu, dass kein Schnee oder Eis von außen in die Führung 16 (Figur 6) eindringen kann. Die Führung 16 wird, wie bei der ersten Ausführungsform zwischen einer oberen Führungsfläche des Deckels 12 und einer unteren Führungsfläche der Membran 30 gebildet. Anders als bei der ersten Ausführungsform wird zusätzlich zu dem Flansch 24 des Massestücks 20 die Dichtung 40 von der Führung 16 eingefasst. Die Dichtung 40 ist an der oberen Gleitfäche des Deckels 12 geführt und kann daran gleiten. Der Abstand zwischen den oberen und unteren Führungsflächen der Führung 16 ist größer als die Dicke des Flanschs 24 mit der Dichtung 40 und zwar um ein entsprechendes Spiel, welches eine sichere geführte Bewegung des Massestücks 20 an der Führung 16 und in der Führungsebene erlaubt. Das Spiel kann nur wenige Millimeter betragen, insbesondere kleiner als 1 mm sein. Ein Spiel von weniger als 0,1 mm ist bevorzugt.

Wenngleich in den gezeigten Beispielen der Deckel eine Öffnung aufweist, ist es auch denkbar, dass der Deckel 12 geschlossen ist. Es von Vorteil, wenn das Massestück sichtbar ist.

## Patentansprüche

1. Schwingungsdämpfer für ein Schneegleitbrett, der Schwindungsdämpfer umfassend:
a) einen Rahmen (10), der an einem Schneegleitbrett befestigt oder befestigbar oder in dem Schneegleitbrett verankert ist,
b) ein Massestück (20), welches relativ zu dem Rahmen (10) bewegbar ist, und
c) ein Elastizitätsmittel (30), an dem das Massestück (20) befestigt ist und das mittels einer Bewegung des Massestücks (20) relativ zu dem Rahmen (10) spannbar ist,
**dadurch gekennzeichnet, dass**
d) der Rahmen (10) eine Führung (16) aufweist, welche das Massestück (20) für Bewegungen in nur einer Ebene führt, wobei das Massestück (20) nur in Richtung der Breite und der Länge des Schneegleitbretts bewegbar ist und Bewegungen des Massestücks (20) entlang der Höhe des Schneegleitbretts oder des Schwingungsdämpfers verhindert werden.

2. Schwingungsdämpfer nach Anspruch 1, **dadurch gekennzeichnet, dass** der Rahmen (10) einen Sockel (11) und einen mit dem Sockel (11) verbundenen Deckel (12) umfasst, wobei das Massestück (20) zwischen Sockel (11) und Deckel (12) geführt ist.

3. Schwingungsdämpfer nach einem der vorhergehenden Ansprüche, **dadurch gekennzeichnet, dass** das Elastizitätsmittel (30) eine elastische Membran (30) ist, die an dem Rahmen (10) befestigt ist, wobei die Membran (30) bevorzugt Silikon, Gummi oder insbesondere thermoplastisches Polyurethan umfasst oder daraus besteht, wobei die Membran vorzugsweise eine Härte von 40 bis 70 Shore-A aufweist.

4. Schwingungsdämpfer nach dem vorhergehenden Anspruch, **dadurch gekennzeichnet, dass** die Membran (30) an mehreren in einer gemeinsamen Befestigungsebene liegenden Befestigungsstellen an dem Rahmen (10) befestigt ist, wobei die Membran (30) gegen Lösen von dem Rahmen (10) an den Befestigungsstellen aufgrund von in oder parallel zu der Befestigungsebene wirkenden oder aufgrund der geführten Bewegung des Massestücks (20) in der Membran (30) hervorgerufenen Spannkräften mittels formschlüssigen Verbindungen zwischen Membran (30) und Rahmen (10) gesichert ist.

5. Schwingungsdämpfer nach einem der zwei vorhergehenden Ansprüche, **dadurch gekennzeichnet, dass** die Membran (30) über ihren Umfang eine Vielzahl von Ausnehmungen (31) und der Rahmen (10) eine Vielzahl von Abragungen (15) aufweist, wobei in je eine Ausnehmung (31) eine Abragung (15) ragt.

6. Schwingungsdämpfer nach einem der vorhergehenden Ansprüche, **dadurch gekennzeichnet, dass** das Massestück (20) quer, vorzugsweise senkrecht zu einer Flächennormalen einer Membran (30) oder einer Befestigungsebene oder parallel zur Befestigungsebene bewegbar geführt ist.

7. Schwingungsdämpfer nach einem der vorhergehenden Ansprüche, **dadurch gekennzeichnet, dass** der Rahmen (10) an seiner der Unterseite gegenüberliegenden Oberseite oder der Deckel (12) eine Öffnung aufweist, durch die das Massestück (20) ragt.

8. Schwingungsdämpfer nach einem der vorhergehenden Ansprüche, **dadurch gekennzeichnet, dass** an der Unterseite des Rahmens (10) eine Klebeschicht (17) angeordnet ist, die z.B. von einer Abziehfolie abgedeckt sein kann, wobei die Klebeschicht (17) vorzugsweise insbesondere geschlossenporigen Acrylschaum umfasst.

9. Schwindungsdämpfer nach einem der vorhergehenden Ansprüche, **dadurch gekennzeichnet, dass** die von der Unterseite zu der Oberseite des Schwingungsdämpfers erstreckte Höhe (h) kleiner ist als seine quer zur Höhe erstrecke Länge (1) und/oder Breite (b), insbesondere nur halb oder ein Drittel so groß ist.

10. Schwindungsdämpfer nach einem der vorhergehenden Ansprüche, **dadurch gekennzeichnet, dass** an dem Massestück (20) eine Dichtung (40) befestigt ist, welche zwischen dem Massestück (20) und dem Deckel (12) des Rahmens (10) angeordnet ist.

11. Gleitbrett, insbesondere Schneegleitbrett, umfassend mindestens einen Schwingungsdämpfer nach einem der vorhergehenden Ansprüche.

12. Gleitbrett nach Anspruch 11, **dadurch gekennzeichnet, dass** das Gleitbrett eine Vorspannung aufweist, wodurch das Gleitbrett, wenn es mit seiner an der Unterseite angeordneten Gleitfläche auf einen ebenen Untergrund aufgelegt wird, mit nur zwei Bereichen, nämlich einem vorderen Auflagebereich und einem hinteren Auflagebereich, auf dem ebenen Untergrund aufliegt, wobei der Bereich zwischen dem vorderen Bereich und dem hinteren Bereich von dem Untergrund abhebt, wobei am vorderen Auflagebereich oder/und am hinteren Auflagebereich, insbesondere auf der der Unterseite gegenüberliegenden Oberseite des Gleitbretts, je ein Schwingungsdämpfer nach einem der Ansprüche 1 bis 10 angeordnet ist.

13. Gleitbrett nach einem der zwei vorhergehenden Ansprüche, **dadurch gekennzeichnet, dass** der Schwingungsdämpfer oder zumindest dessen Rahmen (10) integraler Bestandteil des Gleitbretts ist und vorzugsweise in dem Gleitbrett fest oder unlösbar verankert ist, wobei insbesondere der Rahmen (10) zwischen Oberseite und Unterseite, insbesondere unter der Oberseite oder der die Oberseite bildenden Oberfläche angeordnet ist, wobei die Oberseite oder deren Oberfläche eine Öffnung aufweist, durch welche das Massestück (20) sichtbar ist oder hindurchragt.

## Claims

1. An oscillation damper for a snow sliding board, said oscillation damper comprising:
a) a frame (10) which is or can be fastened to a snow sliding board or which is anchored in the snow sliding board;
b) a weight (20) which can be moved relative to the frame (10); and
c) an elasticity means (30) to which the weight (20) is fastened and which can be tensed relative to the frame (10) by means of a movement of the weight (20),
**characterised in that**
d) the frame (10) comprises a guide (16) which guides the weight (20) for movements in one plane only, wherein the weight (20) can only be moved in the direction of the width and length of the snow sliding board and is prevented from moving along the height of the snow sliding board or oscillation damper.

2. The oscillation damper according to Claim 1, **characterised in that** the frame (10) comprises a base (11) and a cover (12) which is connected to the base (11), wherein the weight (20) is guided between the base (11) and the cover (12).

3. The oscillation damper according to any one of the preceding claims, **characterised in that** the elasticity means (30) is an elastic membrane (30) which is fastened to the frame (10), wherein the membrane (30) preferably comprises or consists of silicone, rubber or in particular thermoplastic polyurethane, wherein the membrane preferably exhibits a Shore A hardness of 40 to 70.

4. The oscillation damper according to the preceding claim, **characterised in that** the membrane (30) is fastened to the frame (10) at multiple fastening points which lie in a common fastening plane, wherein the membrane (30) is secured against detaching from the frame (10) at the fastening points by means of positive-fit connections between the membrane (30) and the frame (10) due to tensing forces which act in or parallel to the fastening plane and which are caused in the membrane (30) by the guided movement of the weight (20).

5. The oscillation damper according to any one of the preceding two claims, **characterised in that** the membrane (30) comprises a multitude of cavities (31) over its circumference and the frame (10) comprises a multitude of projections (15), wherein one projection (15) protrudes into each of the cavities (31).

6. The oscillation damper according to any one of the preceding claims, **characterised in that** the weight (20) is guided such that it can be moved transverse, preferably perpendicular to a surface normal of a membrane (30) or fastening plane or parallel to the fastening plane.

7. The oscillation damper according to any one of the preceding claims, **characterised in that** the cover (12), or the upper side of the frame (10) which lies opposite the lower side, comprises an opening through which the weight (20) protrudes.

8. The oscillation damper according to any one of the preceding claims, **characterised in that** an adhesive layer (17), which can for example be covered by a peel-off film, is arranged on the lower side of the frame (10), wherein the adhesive layer (17) preferably comprises acrylic foam, in particular closed-pore acrylic foam.

9. The oscillation damper according to any one of the preceding claims, **characterised in that** the height (h) extending from the lower side to the upper side of the oscillation damper is smaller than its length (1) and/or width (b) extending transverse to the height, in particular only half or one third as large.

10. The oscillation damper according to any one of the preceding claims, **characterised in that** a gasket (20) which is fastened to the weight (20) is arranged between the weight (20) and the cover (12) of the frame (10).

11. A sliding board, in particular a snow sliding board, comprising at least one oscillation damper according to any one of the preceding claims.

12. The sliding board according to Claim 11, **characterised in that** the sliding board exhibits a bias which causes the sliding board, when its sliding surface arranged on the lower side is placed onto a level substrate, to have only two regions lying on the level substrate, namely a front contact region and a rear contact region, wherein the region between the front region and the rear region is raised off the substrate, wherein an oscillation damper according to any one of Claims 1 to 10 is arranged on (each of) the front contact region and/or the rear contact region, in particular on the upper side of the sliding board which lies opposite the lower side.

13. The sliding board according to any one of the preceding two claims, **characterised in that** the oscillation damper or at least its frame (10) is an integral part of the sliding board and is preferably fixedly or non-detachably anchored in the sliding board, wherein the frame (10) is in particular arranged between the upper side and the lower side, in particular below the upper side or the surface which forms the upper side, wherein the upper side or its surface comprises an opening through which the weight (20) is visible or protrudes.

## Revendications

1. Amortisseur de vibrations pour une planche de glisse sur neige, l'amortisseur de vibrations comprenant :
a) un cadre (10) fixé ou pouvant être fixé sur une planche de glisse sur neige ou étant ancré dans la planche de glisse sur neige,
b) une masse (20) mobile par rapport au cadre (10), et
c) un moyen élastique (30) fixé à la masse (20) et pouvant être tendu par un mouvement de la masse (20) par rapport au cadre (10),
**caractérisé en ce que**
d) le cadre (10) comporte un guidage (16) qui guide la masse (20) pour des mouvements dans un seul plan, où la masse (20) n'est déplaçable que dans la direction de la largeur et de la longueur de la planche de glisse sur neige et où sont empêchés des mouvements de la masse (20) le long de la hauteur de la planche de glisse sur neige ou de l'amortisseur de vibrations.

2. Amortisseur de vibrations selon la revendication 1, **caractérisé en ce que** le cadre (10) comprend un socle (11) et un couvercle (12) connecté au socle (11), où la masse (20) est guidée entre le socle (11) et le couvercle (12).

3. Amortisseur de vibrations selon l'une quelconque des revendications précédentes, **caractérisé en ce que** le moyen élastique (30) est une membrane élastique (30) fixée au cadre (10), où la membrane (30) comprend ou est composée de préférence de silicone, de caoutchouc ou en particulier de polyuréthane thermoplastique, où la membrane a de préférence une dureté de 40 à 70 Shore A.

4. Amortisseur de vibrations selon la revendication précédente, **caractérisé en ce que** la membrane (30) est fixée au cadre (10) en plusieurs points de fixation se trouvant dans un plan de fixation commun, où la membrane (30) est assurée au niveau des points de fixation au moyen de connexions par engagement positif entre la membrane (30) et le cadre (10) pour éviter qu'elle ne se détache du cadre (10) en raison de forces de tension agissant dans ou parallèlement au plan de fixation ou induites dans la membrane (30) par le mouvement guidé de la masse (20).

5. Amortisseur de vibrations selon l'une des deux revendications précédentes, **caractérisé en ce que** la membrane (30) comporte une pluralité d'évidements (31) le long de sa circonférence et que le cadre (10) comporte une pluralité de saillies (15), où une saillie (15) fait saillie dans chacun des évidements (31).

6. Amortisseur de vibrations selon l'une quelconque des revendications précédentes, **caractérisé en ce que** la masse (20) est guidée de manière à être mobile transversalement, de préférence perpendiculairement à une normale à la surface d'une membrane (30) ou d'un plan de fixation ou parallèlement au plan de fixation.

7. Amortisseur de vibrations selon l'une quelconque des revendications précédentes, **caractérisé en ce que** le cadre (10) comporte une ouverture au niveau de son côté supérieur opposé au côté inférieur ou que le couvercle (12) comporte une ouverture, de laquelle dépasse la masse (20).

8. Amortisseur de vibrations selon l'une quelconque des revendications précédentes, **caractérisé en ce qu'**une couche adhésive (17) est disposée sur le côté inférieur du cadre (10), ladite couche pouvant être recouverte par exemple d'une feuille détachable, où la couche adhésive (17) comprend de préférence en particulier une mousse acrylique à cellules fermées.

9. Amortisseur de vibrations selon l'une quelconque des revendications précédentes, **caractérisé en ce que** la hauteur (h) s'étendant du côté inférieur au côté supérieur de l'amortisseur de vibrations est plus petite que sa longueur (1) et/ou largeur (b) s'étendant perpendiculairement à la hauteur, en particulier ne représente que la moitié ou le tiers de celles-ci.

10. Amortisseur de vibrations selon l'une quelconque des revendications précédentes, **caractérisé en ce qu'**un joint (40) disposé entre la masse (20) et le couvercle (12) du cadre (10) est fixé sur la masse (20).

11. Planche de glisse, en particulier planche de glisse sur neige, comprenant au moins un amortisseur de vibrations selon l'une quelconque des revendications précédentes.

12. Planche de glisse selon la revendication 11, **caractérisé en ce que** la planche de glisse présente une précontrainte de sorte que, lorsqu'elle est posée sur une surface plane avec sa surface de glisse disposée sur son côté inférieur, la planche de glisse ne repose sur la surface plane qu'avec deux zones, à savoir une zone d'appui avant et une zone d'appui arrière, où la zone entre la zone avant et la zone arrière est décollée du sol, où un amortisseur selon l'une des revendications 1 à 10 est respectivement disposé au niveau de la zone d'appui avant et/ou de la zone d'appui arrière, en particulier sur le côté supérieur de la planche de glisse opposé au côté inférieur.

13. Planche de glisse selon l'une des deux revendications précédentes, **caractérisé en ce que** l'amortisseur de vibrations ou du moins son cadre (10) fait partie intégrante de la planche de glisse et est de préférence ancré de manière fixe ou non détachable dans la planche de glisse, où en particulier le cadre (10) est disposé entre le côté supérieur et le côté inférieur, en particulier sous le côté supérieur ou la surface formant le côté supérieur, où le côté supérieur ou sa surface comporte une ouverture à travers laquelle la masse (20) est visible ou peut passer.
